(19) Europäisches Patentamt

European Patent Office

Office européen des brevets

(11) EP 0 446 639 B1

(12) EUROPÄISCHE PATENTSCHRIFT

(45) Veröffentlichungstag und Bekanntmachung des Hinweises auf die Patenterteilung:
13.11.1996 Patentblatt 1996/46

(51) Int Cl.⁶: H03M 1/36

(21) Anmeldenummer: 91102121.0

(22) Anmeldetag: 14.02.1991

(54) **Paralleler Analog/Digital-Umsetzer**

Parallel AD-converter

Convertisseur analogique numérique parallèle

(84) Benannte Vertragsstaaten:
AT DE FR GB IT NL

(30) Priorität: 15.02.1990 DE 4004748

(43) Veröffentlichungstag der Anmeldung:
18.09.1991 Patentblatt 1991/38

(73) Patentinhaber: SIEMENS
AKTIENGESELLSCHAFT
80333 München (DE)

(72) Erfinder: Zojer, Bernhard, Dipl.-Ing.
A-9500 Villach (AT)

(56) Entgegenhaltungen:
US-A- 4 928 103

• PROCEEDINGS OF THE 1989 BIPOLAR CIRCUITS AND TECHNOLOGY MEETING 18. September 1989, MINNEAPOLIS USA Seiten 44 - 47 CHUCK LANE '10-bit 60 msps flash adc'
• ELECTRONIC DESIGN Bd. 37, Nr. 25, 14. Dezember 1989, CLEVELAND OHIO US Seiten 29 - 30 , XP000096539 GOODENOUGH 'interpolators put 10-bit 75-mhz ad converters on 8-bit digital process'

## Beschreibung

Die Erfindung betrifft einen Analog/Digital-Umsetzer nach dem Oberbegriff des Patentanspruches 1.

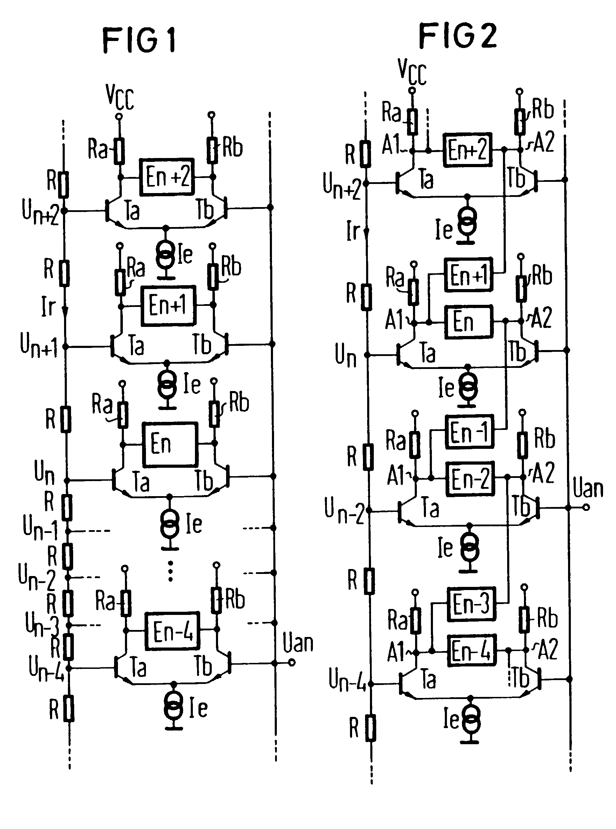

Analog/Digital-Umsetzer sind bekannt. Figur 1 zeigt eine Eingangsstufe mit Differenzverstärkerstufen und Entscheiderstufen eines solchen Analog/Digital-Umsetzers nach dem Stande der Technik

Figur 1 zeigt eine Eingangsstufe eines Analog/Digital-Umsetzers mit einer Vielzahl von Differenzverstärkerstufen, jeweils gebildet aus einem ersten Transistor Ta und einem zweiten Transistor Tb, deren Emitteranschlüsse jeweils an eine Konstantstromquelle Ie angeschlossen sind, die an Bezugspotential geschaltet ist. Der Kollektoranschluß des ersten Transistors Ta bildet jeweils einen ersten Ausgang einer Differenzverstärkerstufe und ist über einen Widerstand Ra an Versorgungspotential Vcc geschaltet. Der Kollektoranschluß des zweiten Transistors Tb bildet jeweils den zweiten Ausgang dieser Differenzverstärkerstufe und ist im Beispiel über einen Widerstand Rb an das Versorgungspotential $V_{CC}$ geschaltet und die beiden Ausgänge der Differenzverstärkerstufen sind jeweils mit den beiden Eingängen einer Entscheiderstufe En, En+1... verbunden. Der Basisanschluß des zweiten Transistors Tb dieser Differenzverstärkerstufen wird jeweils mit dem Analogsignal Uan beaufschlagt, der Basisanschluß des ersten Transistors Ta dieser Differenzverstärkerstufen ist jeweils auf ein festes Potential ... $U_{n-4}$, $U_{n-3}$, $U_{n-2}$, ... geschaltet, wobei dieses feste Potential sich zwischen zwei aufeinanderfolgenden Differenzverstärkerstufen jeweils um einen festen Wert unterscheidet. Das ist dadurch realisiert, daß zwischen den Basisanschlüssen des jeweils ersten Transistors von aufeinanderfolgenden Differenzverstärkerstufen jeweils ein gleich großer Widerstand R derart geschaltet ist, daß alle diese Widerstände R eine Serienschaltung bilden und von einem konstanten Strom Ir durchflossen werden.

Bei solchen bekannten Schaltungen verfälschen die Eingangsströme der Differenzverstärkerstufen die Referenzspannungen. Wenn k die Auflösung des Analog/Digital-Umsetzers ist, so benötigen solche bekannten Schaltungsanordnungen $2^k$ Differenzverstärkerstufen sowie $2^k$ Widerstände R zur Referenzspannungserzeugung.

Der vornehmlich kapazitive Eingangsleitwert einer Differenzverstärkerschaltung führt zu einer Veranderung des Analogsignales. Je mehr Differenzverstärkerschaltungen vom Analogsignal Uan beaufschlagt werden, umso stärker macht sich dieser störende Einfluß bemerkbar. Das dynamische Verhalten eines Analog/Digital-Umsetzers wird durch die Verzerrungen des Analogsignales aufgrund der nichtlinearen Eingangskapazität negativ beeinträchtigt.

Ein eingangs genannter, gattungsbildender A/D-Wandler ist in der Literaturstelle Proceedings of the 1989 Bipolar Circuits and Technology Meeting, 18. September 1989, Minneapolis, USA, Seiten 44 bis 47, Chuck Lane: "10-Bit 60 MSPS-Flash ADC" beschrieben.

Aufgabe der Erfindung ist das Bereitstellen eines Analog/Digital-Umsetzers, der bei gleicher Auflösung eine geringere Anzahl von Differenzverstärkerstufen sowie eine geringere Anzahl von Widerständen in der diesen Differenzverstärkerstufen zugeordneten Referenzspannungserzeugung benötigt.

Diese Aufgabe wird gelöst durch einen Analog/Digital-Umsetzer mit den Merkmalen des Patentanspruches 1.

Günstige Ausgestaltungsformen sind Gegenstand der abhängigen Ansprüche.

In der Figur 2 ist die Eingangsstufe eines Analog/Digital-Umsetzers gezeigt, in der die Prinzipien der obengenannten Literaturstelle angewandt sind. Die Erfindung wird anhand der Ausführungsbeispiele aus den Figuren 3 und 4 näher erläutert.

Figur 2 zeigt die Eingangsstufe eines Analog/Digital-Umsetzers mit einer Vielzahl von Differenzverstärkerstufen Ta, Tb, Ra, Rb, Ie mit jeweils einem ersten und einem zweiten Eingang und einem ersten und einem zweiten Ausgang A1, A2. Die Differenzeingangsspannung zweier aufeinanderfolgender Differenzverstärkerstufen unterscheidet sich jeweils um einen festen Wert, da der Basisanschluß des ersten Transistors Ta jeweils über einen Widerstand R mit dem Basisanschluß des ersten Transistors Ta der beiden benachbarten Differenzverstärkerstufen Ta, Tb, Ra, Rb, Ie verbunden ist.

Die Differenzverstärkerstufen Ta, Tb,... weisen jeweils einen ersten und einen zweiten Ausgang A1, A2 auf. Der erste Ausgang A1 jeder Differenzverstärkerstufe Ta, Tb,... ist jeweils an den ersten Eingang einer Entscheidungsstufe, z.B. En, geschaltet und außerdem ist er an den ersten Eingang einer der beiden Entscheiderstufen En-1; En+1 geschaltet, deren Schaltschwelle sich von der Schaltschwelle dieser Entscheiderstufe En am wenigsten unterscheidet. Der zweite Ausgang A2 jeder Differenzverstärkerstufe Ta, Tb,... ist jeweils an den zweiten Eingang der entsprechenden Entscheiderstufe En geschaltet und außerdem ist er an den zweiten Eingang der anderen der beiden Entscheiderstufen En+1; En-1 geschaltet, deren Schaltschwelle sich von der Schaltschwelle dieser Entscheiderstufe am wenigsten unterscheidet, wobei jede Differenzverstärkerstufe an drei Entscheiderstufen ...; En-1, En, En+1; En-3, En-2, En-1; ... geschaltet ist.

Gegenüber Schaltungen, wie sie in Figur 1 gezeigt sind, benötigen Schaltungen nach Figur 2 zur Realisierung eines Analog/Digital-Umsetzers mit einer Auflösung von k Bit nur $2^{k-1}$ Differenzverstärkerstufen und auch Widerstände R in der Referenzspannungserzeugungsschaltung. Da die Widerstände R in der Referenzspannungserzeugungsschaltung sehr aufwenig zu realisieren sind, bringt eine solche Schaltung wirtschaftliche Vorteile. Außerdem wird das dynamische Verhalten eines solchen Analog/Digital-Umsetzers gegenüber einem nach dem Stande der Technik dadurch verbessert, daß halb so viele Differenzverstärker das Analogsignal Uan belasten, so daß die nichtlinearen Verzerrungen des Analogsignales nicht so groß sind.

Die zwischen zwei verschiedenen Differenzverstärkerstufen geschalteten Entscheiderstufen ..., En-3, En-1, En+1, ... sind derart geschaltet, daß ihre Schaltschwelle genau zwischen den Schaltschwellen der beiden Entscheiderstufen liegen, deren Eingänge jeweils an den beiden Ausgängen einer der Differenzverstärkerschaltungen angeschlossen sind, an deren Ausgänge jeweils die zwischengeschaltete Entscheiderstufe geschaltet ist. Die Entscheiderstufe En+1 schaltet beispielsweise, wenn für das Analogsignal Uan gilt:

$$Uan = \frac{U_n + U_{n+2}}{2}$$

$U_n$ und $U_{n+2}$ sind hierbei Potentiale an zwei Schaltungsknoten, die durch einen Widerstand R getrennt werden. Bei einer Schaltungsanordnung nach Figur 1 entspricht die durch diese Formel eingestellte Schaltschwelle der Schaltschwelle der Entscheiderstufe En+1, wobei der zugeordnete Differenzverstärker mit dem Referenzpotential $U_{n+1}$ beaufschlagt ist.

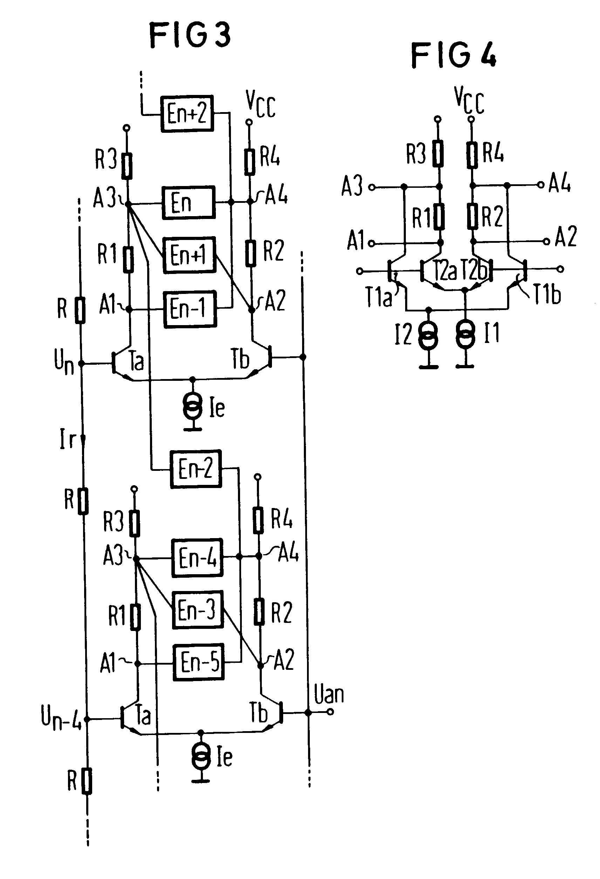

Figur 3 zeigt eine erfindungsgemäße Schaltungsanordnung für den Fall, daß jede Differenzverstärkerschaltung Ta, Tb,... einen ersten A1, einen zweiten A2, einen dritten A3 und einen vierten A4 Ausgang aufweist, wobei das Potential am dritten Ausgang A3 jedes Differenzverstärkers sich immer vom Potential am ersten Ausgang A1 unterscheidet, wobei das Potential am vierten Ausgang A4 jedes Differenzverstärkers sich immer vom Potential am zweiten Ausgang A2 unterscheidet und wobei die Spannung zwischen dem ersten und dem zweiten Ausgang A1, A2 und die Spannung zwischen dem dritten und dem vierten Ausgang A3, A4 - in jedem Betriebsfall - immer das gleiche Vorzeichen aufweisen. D.h., daß der erste mit dem zweiten Ausgang A1, A2 und der dritte mit dem vierten Ausgang A3, A4 jeweils zur Bereitstellung eines symmetrischen Ausgangssignales dieses Differenzverstärkers vorgesehen sind.

Nach dem in Figur 3 gezeigten Ausführungsbeispiel eines solchen Differenzverstärkers besteht er aus einem ersten Transistor Ta und einem zweiten Transistor Tb, deren Emitteranschlüsse mit einer Stromquelle Ie verbunden sind, die an Bezugspotential geschaltet ist. Der Kollektoranschluß des ersten Transistors Ta bildet einen ersten Ausgang A1 der Schaltung und ist über die Serienschaltung zweier Widerstände R1 und R3 an das Versorungspotential $V_{CC}$ geschaltet. Der Verbindungsknoten zwischen dem Widerstand R1 und dem Widerstand R3 bildet den dritten Ausgang A3. Der Kollektor des zweiten Transistors Tb bildet den zweiten Ausgang A2 und ist über die Serienschaltung zweier Widerstände R2 und R4 an das Versorgungspotential $V_{CC}$ geschaltet. Der Verbindungsknoten des Widerstandes R2 und des Widerstandes R4 bildet den vierten Ausgang A4 der Differenzverstärkerschaltung. Die Basisanschlüsse der Transistoren Ta und Tb bilden die beiden Eingangsklemmen dieser Schaltung.

In Figur 3 ist der erste Ausgang A1 jedes Differenzverstärkers Ta, Tb,... mit dem ersten Eingang einer Entscheiderstufe ..., En-5, En-1,... verbunden, deren zweiter Eingang mit dem vierten Ausgang A4 dieses Differenzverstärkers Ta, Tb,... verbunden ist. Außerdem ist der zweite Ausgang A2 jedes Differenzverstärkers mit dem zweiten Eingang der Entscheiderstufe ..., En-3, En+1, ... verbunden, deren erster Eingang mit dem dritten Ausgang A3 dieses Differenzverstärkers Ta, Tb, ... verbunden ist. Weiterhin ist jeder Differenzverstärkerschaltung Ta, Tb, ... eine Entscheiderstufe ..., En-4, En, ... zugeordnet, deren beiden Eingänge jeweils mit ein symmetrisches Ausgangssignal dieser Differenzverstärkerschaltung Ta, Tb, ... bereitstellenden Ausgängen A3, A4 verbunden sind. Es wäre auch möglich, hierzu die Ausgänge A1 und A2 zu verwenden. Der erste dieser Ausgänge, hier der dritte A3, alternativ der erste Ausgang A1 mit dem ersten Eingang einer Entscheiderstufe ..., En-2, En+2, ... verbunden ist, deren zweiter Eingang mit dem dem zweiten dieser Ausgänge entsprechenden Ausgang, hier mit dem vierten Ausgang A4, alternativ mit dem zweiten Ausgang A2 der mit der um den kleinsten Wert kleineren Differenzspannung angesteuerten Differenzverstärkerschaltung verbunden ist.

Figur 4 zeigt eine weitere mögliche Differenzverstärkerstufe zur Verwendung in einer Schaltungsanordnung nach Figur 3. Der erste Schaltungseingang dieser Differenzverstärkerstufe wird gebildet durch die Basisanschlüsse eines Transistors T1a und eines Transistors T2a. Der zweite Schaltungseingang dieser Differenzverstärkerstufe wird gebildet durch die Basisanschlüsse zweier Transistoren T1b und T2b. Der Emitteranschluß des Transistors T1a ist gemeinsam mit dem Emitteranschluß des Transistors T1b über eine Konstantstromquelle I2 an Bezugspotential geschaltet. Der Emitteranschluß des Transistors T2a ist gemeinsam mit dem Emitteranschluß des Transistors T2b über eine weitere Stromquelle I1 an Bezugspotential geschaltet. Der Kollektoranschluß des Transistors T2a bildet den ersten Ausgang A1 der Differenzverstärkerstufe und ist über die Serienschaltung zweier Widerstände R1 und R3 an das Versorgungspotential $V_{CC}$ geschaltet. Der Verbindungsknoten zwischen den Widerständen R1 und R3 bildet den dritten Ausgang der Differenzverstärkerstufe und ist mit dem Kollektoranschluß des Transistors T1a verbunden. Der Kollektoranschluß des Transistors T2b bildet den zweiten Ausgang A2 der Differenzverstärkerstufe und ist über die Serienschaltung zweier Widerstände R2 und R4 an das Versorgungspotential $V_{CC}$ geschaltet. Der Verbindungsknoten der Widerstände R2 und R4 bildet den vierten Ausgang A4 der Differenzverstärkerstufe und ist mit dem Kollektoranschluß des Transistors T1b verbunden. Bei einer solchen Schaltungsanordnung ist die Variation der Schaltschwelle der zwischengeschalteten Entscheiderstufen nicht nur durch das Widerstandsverhältnis R1 zu R3 bzw. R2 zu R4 einstellbar, sondern auch durch das Verhältnis der Ströme l1 zu l1 + l2.

Um mit einer Schaltungsanordnung nach Figur 3 einen Analog/Digital-Umsetzer mit einer Auflösung von k Bit bereitzustellen, sind $2^{k-2}$ Differenzverstärkerstufen und auch $2^{k-2}$ Widerstände R pro Referenzspannungserzeugungsschaltung erforderlich.

Wenn $U_{LSB}$ der Abstand der Schaltschwellen zweier benachbarter Entscheiderstufen in einer Schaltungsanordnung nach Figur 3 ist, wenn $U_T$ die sogenannte Temperaturspannung ($U_T = kT/q$) ist und wenn die Widerstände R1 und R2 den Widerstandswert R1 haben und die Widerstände R3 und R4 den Widerstandswert R3, so sind die Schaltschwellen unter der Voraussetzung, daß $U_{LSB}$ klein ist gegen $U_T$ korrekt eingestellt, wenn gilt:

$$\frac{U_{LSB}}{U_T} = \frac{R1}{R3}$$

Bei Verwendung von Differenzverstärkerschaltungen nach Figur 4 ändert sich die Gleichung in:

$$\frac{U_{LSB}}{U_T} = \frac{R1 \cdot l1}{R3 \, (l1 + l2)}$$

Ein weiterer Vorteil von Schaltungen mit zwei Widerständen im Kollektorkreis der Differenzverstärkerstufen ist darin zu sehen, daß aufgrund der geringen Auflösung der Verstärker beliebig nichtlineares Verhalten aufweisen kann. Die Temperaturabhängigkeit kann durch ein entsprechendes Widerstandsverhältnis beseitigt werden. Außerdem ist die Schaltung vollkommen unabhängig von dem gewählten Strom le. Ein linearer Verstärker ist nicht erforderlich.

**Patentansprüche**

1. Analog/Digital-Umsetzer mit Eingangsstufe, mit Codierstufen und Ausgangsstufen, wobei die Eingangsstufe eine Vielzahl von Differenzverstärkerstufen (Ta, Tb, R1, R2, R3, R4 le) mit jeweils einem ersten und einem zweiten Eingang und mindestens einem ersten und einem zweiten Ausgang enthält und die Differenzeingangsspannung zweier aufeinanderfolgender Differenzverstärkerstufen sich jeweils um einen festen Wert unterscheidet und wobei den Differenzverstärkerstufen (Ta, Tb, R1, R2, R3, R4, le) Entscheiderstufen (..., En-2, En-1, En, En+1, ...) mit jewils einem ersten und einem zweiten Eingang nachgeschaltet sind, die Anzahl der Entscheiderstufen (..., En-2, En-1, En, En+1,...)

größer ist als die Anzahl der Differenzverstärkerstufen (Ta, Tb, R1, R2, R3, R4, le), jede Differenzverstärkerstufe eine geradzahlige Anzahl von Ausgängen (A1, A2, A3, A4) aufweist und jeder Ausgang jeder Differenzverstärkerstufe mit je einem Eingang mehrerer Entscheiderstufen (..., En-2, En-1, En, En+1,...) derart verbunden ist, daß alle Entscheiderstufen (..., En-2, En-1, En, En+1,...) unterschiedliche Schaltschwellen aufweisen, **dadurch gekennzeichnet,**

- daß jede Differenzverstärkerstufe (Ta, Tb,...) einen ersten (A1), einen zweiten (A2), einen dritten (A3) und einen vierten (A4) Ausgang aufweist, wobei das Potential am dritten Ausgang (A3) jedes Differenzverstärkers sich immer vom Potential am ersten Ausgang (A1) unterscheidet, wobei das Potential am vierten Ausgang (A4) jedes Differenzverstärkers sich immer vom Potential am zweiten Ausgang (A2) unterscheidet und wobei die Spannung zwischen dem ersten und dem zweiten Ausgang (A1, A2) und die Spannung zwischen dem dritten und dem vierten Ausgang (A3, A4) - in jedem Betriebsfall - immer das gleiche Vorzeichen aufweisen, d. h. daß der erste mit dem zweiten Ausgang (A1, A2) und der dritte mit dem vierten Ausgang (A3, A4) jeweils zur Bereitstellung eines symmetrischen Ausgangssignales dieses Differenzverstärkers (Ta, Tb,...) vorgesehen sind,
- daß der erste Ausgang (A1) jedes Differenzverstärkers (Ta, Tb,...) mit dem ersten Eingang einer Entscheiderstufe (..., En-5, En-1,...) verbunden ist, deren zweiter Eingang mit dem vierten Ausgang (A4) dieses Differenzverstärkers (Ta, Tb, ...) verbunden ist,
- daß der zweite Ausgang (A2) jedes Differenzverstärkers mit dem zweiten Eingang der Entscheiderstufe (..., En-3, En+1, ...) verbunden ist, deren erster Eingang mit dem dritten Ausgang (A3) dieses Differenzverstärkers (Ta, Tb, ...) verbunden ist,
- daß jeder Differenzverstärkerstufe (Ta, Tb,...) eine Entscheiderstufe (..., En-4, En, ...) zugeordnet ist, deren beiden Eingänge jeweils mit ein symmetrisches Ausgangssignal dieser Differenzverstärkerstufe (Ta, Tb, ...) bereitstellenden Ausgängen (A1, A2 oder A3, A4) verbunden sind,
- und daß der erste dieser Ausgänge (A1 bzw. A3) mit dem ersten Eingang einer Entscheiderstufe (..., En-2, En+2, ...) verbunden ist, deren zweiter Eingang mit dem dem zweiten dieser Ausgänge (A2 bzw. A4) entsprechenden Ausgang (A2 bzw. A4) der mit der um den kleinsten Wert kleineren Differenzspannung angesteuerten Differenzverstärkerstufe verbunden ist.

**2.** Analog/Digital-Umsetzer nach Anspruch 1, **dadurch gekennzeichnet**, daß jede Differenzverstärkerstufe (Ta, Tb, ...) ein emittergekoppeltes Transistorpaar (Ta, Tb; T2a, T2b) enthält, daß der erste Eingang der Differenzverstärkerstufe mit dem Basisanschluß des ersten Transistors (Ta; T2a) des Transistorpaares verbunden ist und der zweite Eingang mit dem Basisanschluß des zweiten Transistors (Tb; T2b), daß in die Kollektorzweige der Transistoren (Ta, Tb; T2a, T2b) des Transistorpaares je zwei Widerstände (R1, R2, R3, R4) in Reihe geschaltet sind, und daß die transistorseitigen Anschlüsse der Widerstände (R1, R2, R3, R4) je einen der Ausgangsanschlüsse (A1, A2, A3, A4) bilden.

**3.** Analog/Digital-Umsetzer nach Anspruch 2, **dadurch gekennzeichnet**, daß die Differenzverstärkerstufe (Ta, Tb, ...) ein weiteres Transistorpaar mit emittergekoppelten Transistoren (T1a, T1b) enthält, daß die Kopplungsknoten der Transistoren (T2a, T2b; T1a, T1b) jeweils über eine Stromquelle (I1, I2) mit einem Anschluß für ein Bezugspotential verbunden sind, daß die Basisanschlüsse der Transistoren (T1a, T1b) des zweiten Transistorpaares an die Basisanschlüsse der Transistoren (T2a, T2b) des ersten Transistorpaares gekoppelt sind und daß die Kollektoren der Transistoren (T1a, T1b) des zweiten Transistorpaares mit dem transistorseitigen Anschluß der zweiten Widerstände (R3, R4) verbunden sind.

**Claims**

**1.** Analog/digital converter having an input stage, having coding stages and output stages, the input stage containing a large number of differential amplifier stages (Ta, Tb, R1, R2, R3, R4 Ie) each having a first input and a second input and at least one first output and one second output, and the differential input voltage of two successive differential amplifier stages in each case differing by a fixed value, and the differential amplifier stages (Ta, Tb, R1, R2, R3, R4, Ie) having connected downstream from them decision stages (..., En-2, En-1, En, En+1, ...) each having a first input and a second input, the number of decision stages (..., En-2, En-1, En, En+1, ...) being greater than the number of differential amplifier stages (Ta, Tb, R1, R2, R3, R4, Ie), each differential amplifier stage having an even number of outputs (A1, A2, A3, A4), and each output of each differential amplifier stage being connected to in each case one input of a plurality of decision stages (...., En-2, En-1, En, En+1,...) in such a manner that all the decision stages (..., En-2, En-1, En, En+1, ...) have different switching thresholds, characterized

- in that each differential amplifier stage (Ta, Tb, ...) has a first (A1), a second (A2), a third (A3) and a fourth (A4) output, the potential at the third output (A3) of each differential amplifier always differing from the potential at the first output (A1), the potential at the fourth output (A4) of each differential amplifier always differing from the potential at the second output (A2), and the voltage between the first and the second output (A1, A2) and the voltage between the third and the fourth output (A3, A4) - in each operational case - always having the same mathematical sign, that is to say that the first together with the second output (A1, A2) and the third together with the fourth output (A3, A4) are in each case intended to provide a balanced output signal from this differential amplifier (Ta, Tb, ...),

- in that the first output (A1) of each differential amplifier (Ta, Tb, ...) is connected to the first input of a decision stage (..., En-5, En-1, ...) whose second input is connected to the fourth output (A4) of this differential amplifier (Ta, Tb, ...),

- in that the second output (A2) of each differential amplifier is connected to the second input of the decision stage (..., En-3, En+1, ...), whose first input is connected to the third output (A3) of this differential amplifier (Ta, Tb, ...),

- in that each differential amplifier stage (Ta, Tb, ...) is assigned a decision stage (..., En-4, En, ...) whose two inputs are each connected to outputs (A1, A2 or A3, A4) which provide a balanced output signal from this differential amplifier stage (Ta, Tb, ...),

- and in that the first of these outputs (A1 or A3 respectively) is connected to the first input of a decision stage (..., En-2, En+2,...), whose second input is connected to that output (A2 or A4 respectively) which corresponds to the second of these outputs (A2 or A4 respectively) of the differential amplifier stage which is driven by that difference voltage which is smaller by the smallest value.

**2.** Analog/digital converter according to Claim 1, characterized in that each differential amplifier stage (Ta, Tb, ...) contains an emitter-coupled transistor pair (Ta, Tb; T2a, T2b), in that the first input of the differential amplifier stage is connected to the base connection of the first transistor (Ta; T2a) of the transistor pair, and the second input is connected to the base connection of the second transistor (Tb; T2b), in that in each case two resistors (R1, R2, R3, R4) are connected in series in the collector paths of the transistors (Ta, Tb; T2a, T2b) of the transistor pair, and in that both connections of the resistors (R1, R2, R3, R4) which are on the transistor side each form one of the output connections (A1, A2, A3, A4).

3. Analog/digital converter according to Claim 2, characterized in that the differential amplifier stage (Ta, Tb, ...) contains a further transistor pair with emitter-coupled transistors (T1a, T1b), in that the coupling nodes of the transistors (T2a, T2b; Tla, Tlb) are each connected via a current source (I1, I2) to a connection for a reference-earth potential, in that the base connections of the transistors (T1a, T1b) of the second transistor pair are coupled to the base connections of the transistors (T2a, T2b) of the first transistor pair, and in that the collectors of the transistors (T1a, T1b) of the second transistor pair are connected to that connection of the second resistors (R3, R4) which is on the transistor side.

**Revendications**

1. Convertisseur analogique/numérique comportant un étage d'entrée, des étages de codage et des étages de sortie, l'étages d'entrée comprenant une multiplicité d'étages amplificateurs différentiels (Ta, Tb, R1, R2, R3, R4, Ie) comportant chacun une première et une deuxième entrées et au moins une première et une seconde sorties et les tensions d'entrée de différence de deux étages amplificateurs différentiels se suivant différents d'une valeur fixe, des étages de décision (..., En-2, En-1, En, En+1) comportant chacun une première et une deuxième entrées étant branchées en aval des étages amplificateurs différentiels (Ta, Tb, R1, R2, R3, R4, Ie), le nombre des étages de décision (..., En-2, En-1, En, En+1,...) étant plus grand que le nombre des étages amplificateurs différentiels (Ta, Tb, R1, R2, R3, R4, Ie), chaque étage amplificateur différentiel comportant un nombre pair de sorties (A1, A2, A3, A4) et chaque sortie de chaque étage amplificateur différentiel étant reliée à une entrée de plusieurs étages de décision (..., En-2, En-1, En, En+1), de telle sorte que tous les étages de décision (..., En-2, En-1, En, En+1,...) aient des seuils de commutation différents,

**caractérisé en ce que**

- chaque étage amplificateur différentiel (Ta, Tb,...) comporte une première sortie (A1), une deuxième sortie (A2), une troisième sortie (A3) et une quatrième sortie (A4), le potentiel de la première sortie A3 de chaque amplificateur différentiel différant toujours du potentiel de la troisième sortie (A1), le potentiel de la quatrième sortie (A4) de chaque amplificateur différentiel différant toujours du potentiel de la deuxième sortie (A2), la tension entre les première et deuxième sorties (A1, A2) et la tension entre les troisième et quatrième sorties (A3, A4), ayant toujours le même signe dans chaque cas de fonctionnement, c'est-à-dire que la première sortie est prévue avec la deuxième sortie (A1, A2) et la troisième sortie est prévue avec la quatrième sortie (A3, A4), pour tenir prêt un signal symétrique de sortie de cet amplificateur différentiel (Ta, Tb, ...),

- la première sortie (A1) de chaque amplificateur différentiel (Ta, Tb) est reliée à la première entrée d'un étage de décision (..., En-5, En-1) dont la deuxième entrée est reliée à la quatrième sortie (A4) de cet amplificateur différentiel (Ta, Tb,...),

- la deuxième sortie (A2) de chaque amplificateur différentiel est reliée à la deuxième entrée de l'étage de décision (...,En-3, En+1,...), dont la première entrée est reliée à la troisième sortie (A3) de cet amplificateur différentiel (Ta, Tb,...),

- il est associé à chaque étage amplificateur différentiel (Ta, Tb,...)un étage de décision (..., En-4, En,...), dont les deux entrées sont reliées à des sorties (A1, A2 ou A3, A4) tenant prêt un signal symétrique de sortie de cet étage amplificateur différentiel (Ta,

- la première de ces sorties (A1 ou A3) est reliée à la première entrée d'un étage de décision (..., En-2, En+2), dont la deuxième entrée est reliée à la sortie (A2 ou A4), qui correspond à la deuxième de ces sorties (A2 ou A4), de l'étage amplificateur différentiel commandé par la tension de différence plus petite de la valeur minimum.

2. Convertisseur analogique/numérique suivant la revendication 1,

**caractérisé en ce que**

chaque étage amplificateur différentiel (Ta, Tb,...) comprend une paire de transistors (Ta, Tb... T2a, T2b) à éviteurs couplés, la première entrée de l'étage amplificateur différentiel est reliée à la borne de base du premier transistor (Ta ; T2a) de la paire de transistors, la deuxième entrée est reliée à la borne de base du deuxième transistor (Tb ; T2b), deux résistances (R1, R2, R3 , R4) sont branchées en série dans les branches de collecteur des transistors (Ta, Tb ; T2a, T2b) de la paire de transistors et les bornes des résistances (R1, R2, R3, R4) qui sont du côté du transistor forment chacune l'une des bornes de sortie (A1, A2, A3, A4).

3. Convertisseur analogique/numérique suivant la revendication 2,

**caractérisé en ce que,**

l'étage amplificateur différentiel (Ta, Tb,...) comprend une autre paire de transistors (T1a, T1b) à émetteurs couplés, les noeuds de liaison des transistors (T2a, T2b ; T1a, T1b) sont reliés chacun à une borne pour un potentiel de référence par l'intermédiaire d'une source (I1, I2) de courant, les bornes de base des transistors (T1a, T1b) du deuxième couple de transistors sont couplés aux bornes de base des transistors (T2a, T2b) de la première paire de transistors et les collecteurs des transistors (T1a, T1b) de la deuxième paire de transistors sont reliés à la borne, du côté transistor, des deuxièmes résistances (R3, R4).

# FIG 1

# FIG 2

## FIG 3

## FIG 4